Europäisches Patentamt

(19) European Patent Office

Office européen des brevets

(11) Publication number: **0 071 470**
**B1**

(12) **EUROPEAN PATENT SPECIFICATION**

(45) Date of publication of patent specification: **08.06.88**

(51) Int. Cl.⁴: **G 11 C 11/40, G 11 C 5/06**

(21) Application number: **82303981.3**

(22) Date of filing: **28.07.82**

(54) Semiconductor memory device including a wordline discharge.

(30) Priority: **29.07.81 JP 118613/81**

(43) Date of publication of application:
**09.02.83 Bulletin 83/06**

(45) Publication of the grant of the patent:
**08.06.88 Bulletin 88/23**

(84) Designated Contracting States:
**DE FR GB**

(56) References cited:
**EP-A-0 011 448**
**EP-A-0 019 241**
**EP-A-0 023 655**
**EP-A-0 025 316**
**EP-A-0 030 422**

**PATENTS ABSTRACTS OF JAPAN, vol. 2, no.
33, 06-03-1978, & JP - A - 52 155 928 (NIPPON
DENSHIN DENWA KOSHA)(24-12-1977).
Idem**

(73) Proprietor: **FUJITSU LIMITED**
**1015, Kamikodanaka Nakahara-ku
Kawasaki-shi Kanagawa 211 (JP)**

(72) Inventor: **Aoyama, Keizo
11-28, Tsukimino 1-chome
Yamato-shi Kanagawa 242 (JP)**

(74) Representative: **Skone James, Robert Edmund
et al
GILL JENNINGS & EVERY 53-64 Chancery Lane
London WC2A 1HN (GB)**

Courier Press, Leamington Spa, England.

## Description

The present invention relates to semiconductor memory devices. In particular, it relates to a circuit for discharging the word lines of a semiconductor memory device.

A semiconductor memory device consists of a plurality of word lines intersecting with a plurality of transverse bit lines to form an array with memory cells being positioned at each of the intersecting points. In a static memory, memory cells are usually constructed in the form of a flip-flop circuit. In the metal-oxide semiconductor (MOS)-type memory cell, a pair of signal input/output terminals of the flip-flop circuit is connected to a pair of bit lines via transfer gates (MOS transistors), and the gate electrode wirings of the MOS transistors serve as word lines. The gate electrode wirings are usually formed from polycrystalline silicon, which has a relatively large resistance and creates a static capacity relative to the substrate to establish a large time constant. If the word line has a large time constant as determined by the product of the resistance and the capacity, the potential of a word line remote from the selected word driver cannot immediately respond to a change in the output of the selected word driver from a low level to a high level; i.e. operation is delayed.

EP—A2—0023655 and EP—A1—0019241 each describe a semiconductor memory device comprising a plurality of memory cells arranged in a row, a word line connected to the plurality of memory cells for selecting the memory cells, and drive means connected to the word line for switching the word line between a selected state and a non-selected state. The device has a positive feedback amplifier connected to the word line at a position spaced from the drive means connection. According to one embodiment, the positive feedback amplifier comprises a transistor for discharging the word line. This transistor is activated whenever the word line changes state. These circuits suffer from a problem when the word line is switched from a non-selected state to a selected state. This switch is delayed due to the discharging affect of the transistor.

In accordance with the present invention, a semiconductor memory device comprises a plurality of memory celles arranged in a row; a word line operatively connected to the plurality of memory cells for selecting the memory cells; drive means connected to the word line for switching the word line from a selected state to a non-selected state and from the non-selected state to the selected state; at least one transistor connected to the word line at a position spaced from the drive means for discharging the word line; and a means for turning on the at least one transistor, the means for turning on the at least one transistor begin adapted to apply a pulse to the at least one transistor when the associated word line is switched from the selected state to the non-selected state to turn on the at least one transistor for at most a predetermined period of time and including a pulse generating means for generating the pulse and is characterised in that the means for turning on the at least one transistor further includes a gate means connected between the pulse generating means and the at least one transistor, the gate means being responsive to the selected state or non-selected state of the associated word line so as to inhibit passage of the pulse therethrough when the associated word line is in a non-selected state and to allow the pulse to pass therethrough to the at least one transistor when the associated word line is in the selected state, thereby accelerating the discharge of the word line from the selected state to the non-selected state without affecting the change from the non-selected state to the selected state.

With this invention the above-mentioned defects are eliminated and a circuit is provided for driving a semiconductor memory, in which circuit the output potential of a word line remote from the selected word driver can, without a delay, respond to a change in the output level of the word driver during non-selection and also retains that ability to switch rapidly to a selection state.

Preferably, the gate means comprises a first control transistor having a gate connected to the word line; and a second control transistor connected between a gate of the transistor and a ground potential point, wherein the pulse generating means generates a reset signal and a logical complement of the reset signal, the reset signal being generated for a predetermined period when the word line is switched from the selected state to the non-selected state, the reset signal being applied to the gate of the at least one transistor via the first control transistor and the logical complement of the reset signal being applied to a gate of the second control transistor, and the first control transistor being operable to inhibit the application of the reset signal to the at least one transistor when the word line is switched from the non-selected state to the selected state.

Some examples of semiconductor memory devices in accordance with the present invention will now be described and contrasted with some previous proposals with reference to the accompanying drawings, in which:—

Figure 1A illustrates one example of a prior proposal of a circuit for driving the word lines of a semiconductor memory device;

Figure 1B illustrates waveforms in various portions of the circuit;

Figures 2A, 3A and 4A illustrate other prior proposed circuits for driving word lines

Figures 2B, 3B and 4B are diagrams showing the rising and falling portions of the waveform at various positions in the circuits of Figures 2A, 3A, and 4A;

Figure 5A illustrates a circuit which provides a reset signal for the circuit of Figure 4A;

Figure 5B is a timing chart illustrating the operation of the circuit shown in Figure 5A;

Figure 6A illustrates another known circuit for driving word lines;

Figure 6B is a diagram showing the rising and falling portions of the waveform at various positions in the circuit;

Figures 7A, 8A and 8B illustrate further known examples of circuits for driving word lines:

Figure 7B is a diagram showing the rising and falling portions of the waveform at various positions in the circuit of Figure 7A;

Figure 9A illustrates a first example of a circuit according to the present invention;

Figure 9B illustrates a part of Figure 9A;

Figure 9C is a diagram showing the rising and falling portions of the waveform at various positions in the circuit of Figure 9A;

Figure 9D is a timing chart showing the operation of the detailed circuit of Figure 9C;

Figure 10A is a block diagram of a second example of a circuit according to the present invention; and,

Figure 10B is a diagram showing the operation of the circuit of Figure 10A.

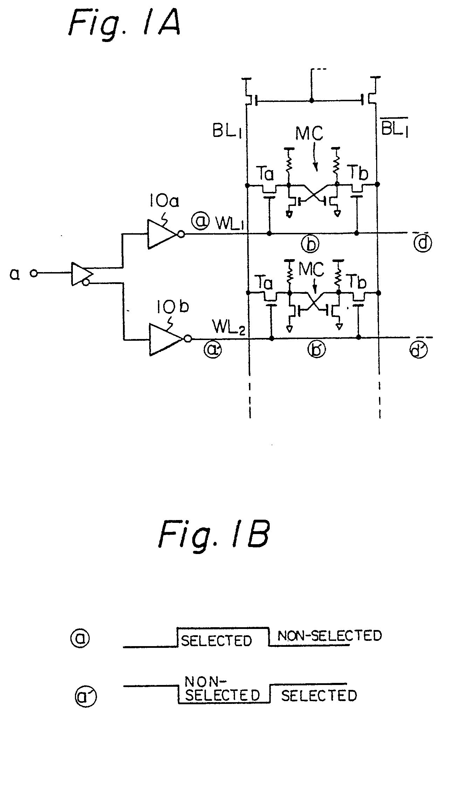

Figure 1A illustrates word lines $WL_1$, $WL_2$ ..., bit lines $BL_1$, $\overline{BL}_1$, ..., and memory cells MC arranged at cross points of the word lines and the bit lines. In static memory cells, memory cells MC are usually formed as a flip-flop circuit shown in Figure 1A, a pair of signal input terminals of the flip-flop circuit is connected via transfer gates $T_a$, $T_b$ (MOS transistors) to a pair of bit lines $BL_1$, $\overline{BL}_1$, and wirings connected to gates of MOS transistors $T_a$, $T_b$ are used as word lines $WL_1$, $WL_2$, .... Figure 1B shows output waveforms of word drivers 10a and 10b, and a word line is at a high voltage level when it is selected.

In Figure 1A, word lines $WL_1$, $WL_2$, ... are usually made of polysilicon. Polysilicon word lines have a relatively large resistance so that static capacitance exists with respect to the substrate. Therefore, when the capacity of the memory increases and the length of the word lines increaess, a large time constant exists in each word line.

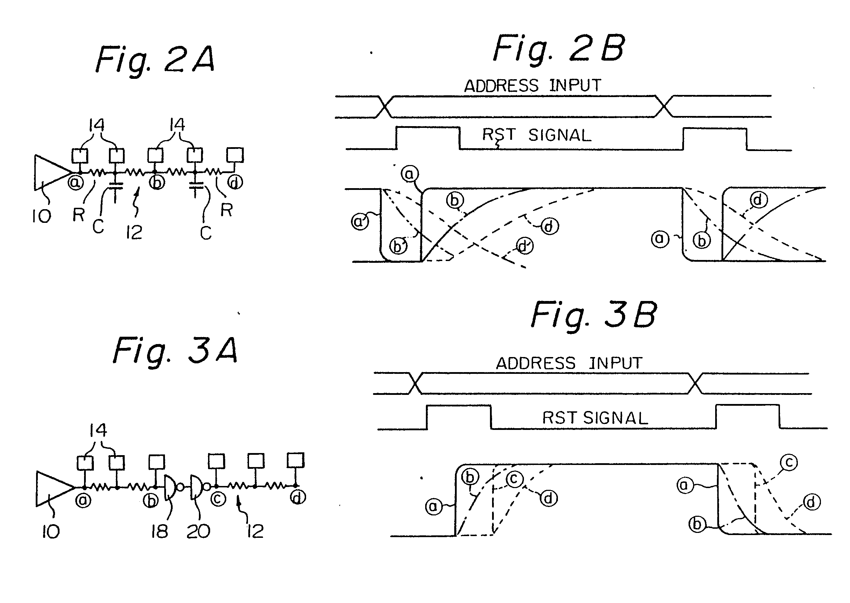

In Fig. 2A. a delay in operation is illustrated. In the figure, 10 denotes a word driver, 12 denotes a word line, 14 denotes a plurality of memory cells, R denotes the resistance of the word line, and C denotes the stray capacitance. When the word line has a large time constant, if word driver 10 is selected and the output of word driver 10 is changed from a low level to a high level, a change in the portion of the word line which is remote from the word driver cannot immediately respond to the output of word driver 10, as shown in Fig. 2B. In Fig. 2B, ⓐ denotes a change in the output potential of word driver 10, ⓑ and ⓓ, respectively, denote a change in the potential in portions ⓑ, and ⓓ in Fig. 2A, and ⓐ′, ⓑ′, and ⓓ′, respectively, denote a change in the potential of the same portions of another word line previously selected. As shown in Fig. 2B, the rising of and falling of the potential of the word line at intermediate points ⓑ and ⓑ′ are slow and become slower in the end potions ⓓ and ⓓ′. When the timing of the variation of the potential in the word line is varied as shown in Fig. 2B, much time is required for reading or writing data so that high-speed operation cannot be carried out. Further, a phenomenon such as malselection or multi-selection may occur.

For the purpose of eliminating the abovementioned disadvantage and of speeding up the rising portion of the word lines, a relay buffer or amplifier may be provided at an intermediate portion of the word lines, as shown in Fig. 3A. In Fig. 3A, two inverters 18 and 20 connected in series serve as relay buffers and are connected to word line 12. In this case, potential changes at points ⓐ, ⓑ, ⓒ, and ⓓ on word line 12 are as represented in Fig. 3B. That is, the potential at point ⓑ rises more gradually than at point ⓐ, which is the output terminal of the word driver. At point ⓒ, however, the potential rises sharply owing to the shaping function of the two stages of the inverters, and the potential rises quite sharply at point ⓓ. However, in the circuit shown in Fig. 3A, the rising point is delayed due to the shaping action of inverters 18 and 20 so that the falling point also is delayed. Accordingly, the circuit shown in Fig. 3A is also unfavorable.

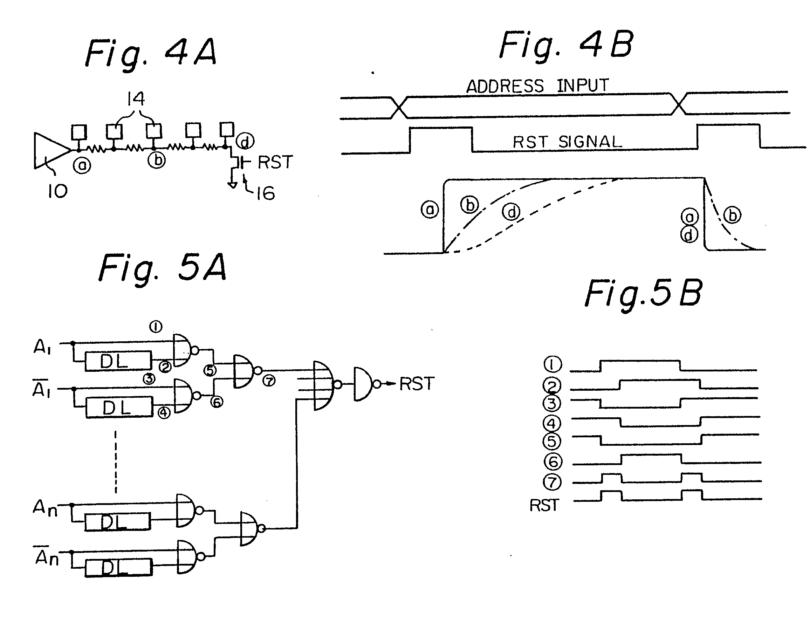

Figure 4A illustrates another known circuit circuit in which the falling portion of the electric potential on the word line is improved by providing a discharging transistor 16 at the end of the word line. That is, reset signal RST is generated when the electric potential falls on the word line, i.e., when the word line is switched from the selected state to the nonselected state. Here, reset signal RST is applied to transistor 16 to temporarily turn on the transistor so that the word line is discharged and the electric potential is more rapidly decreased. The change in potential at each of the portions of the word line is shown in Fig. 4B, in which chain line ⓑ represents the potential at intermediate point ⓑ and dotted line ⓓ represents the potential at end portion ⓓ. It can be seen that the potential falls steeply at end portion ⓓ and also falls more quicly at intermediate point ⓑ compared with when there is no transistor 16.

Figure 5A illustrates a circuit which generates reset signal RST applied to transistor 16 in Fig. 4A, and Fig. 5B illustrates a time chart of the waveform in the essential portions of the circuit shown in Fig. 5A. In the reset signal generating circuit shown in Fig. 5A, address signals $A_1 \sim A_n$ and inverted address signals $\overline{A}_1 \sim \overline{A}_n$ are supplied to input terminals thereof, and a pulse having a constant width is generated when the address input is changed. The width of reset pulse RST generated is determined by the delay time of delay circuit DL.

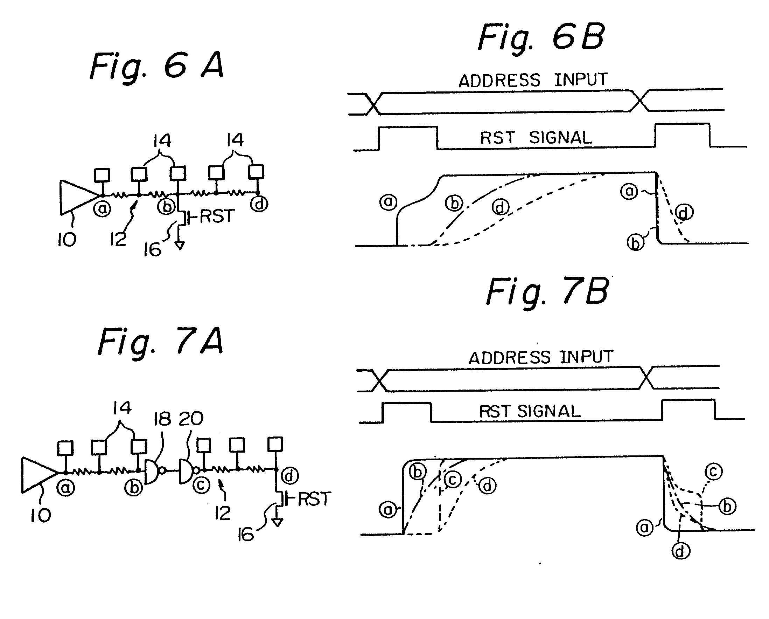

Figure 6A illustrates a known circuit for further improving the falling characteristic in the embodiment shown in Fig. 4A. As can be seen by comparing the embodiment of Fig. 6A with the circuit shown in Fig. 4A, in the embodiment shown in Fig. 6A, discharging transistor 16 is connected to word line 12 at an intermediate point thereof. In the circuit in Fig. 6A, the falling characteristics of the electric potential at the intermediate point becomes sharp so that the falling characteristic of the electric potential at the end point becomes sharp. Therefore, the variation of the characteristic at points ⓐ, ⓑ, and ⓓ of the word line when the electric potential on the word line is high can be lessened.

However, in the circuit shown in Fig. 6A, the rising characteristic of the electric voltage level cannot be improved and an abnormal phenomenon occurs therein. The reason for this is that if reset signal RST is still at a high voltage level at the time when the rising of point ⓐ of the word line is transmitted to point ⓑ, the electric voltage at point ⓑ cannot rise up and a current flows from word driver 10 to RST transistor 16. Therefore, it is necessary to determine the pulse timing of the RST signal within a range in which no such phenomenon occurs.

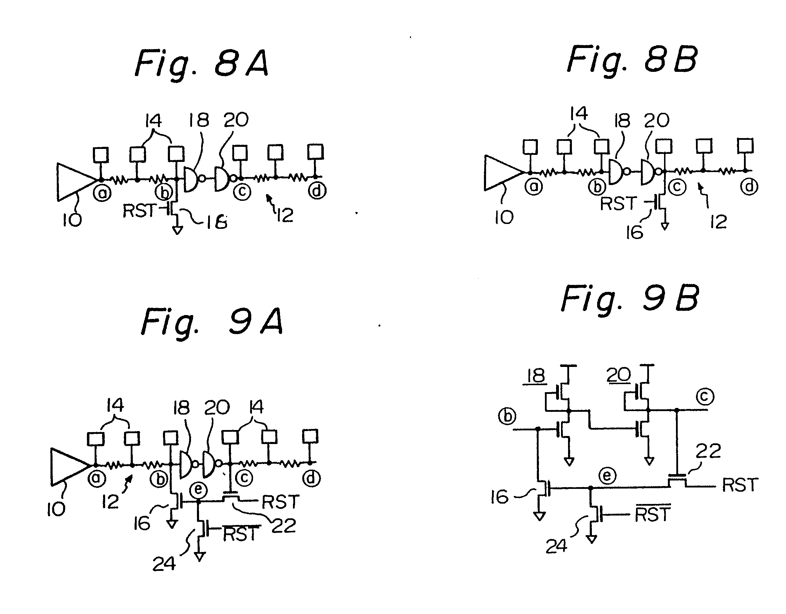

The circuits shown in Fig. 7A, Fig. 8A, and Fig. 8B can be obtained by combining discharge transistor 16 and relay buffers 18 and 20. In Fig. 7A, transistor 16 is provided at the end of the word line; in Fig. 8A, transistor 16 is provided at the input of relay buffers 18 and 20; and in Fig. 8B, transistor 16 is provided at the output of relay buffers 18 and 20. In the circuit shown in Fig. 8A, as in the case of Fig. 6A, it is necessary to determine the pulse timing of the RST signal so that transistor 16 is not switched to the on state by reset signal RST when the output of word driver 10 rises up. In the circuit shown in Fig. 7A, the rising characteristic of the electric voltage on the word line can be improved as shown in Fig. 7B. However, an abnormal phenomenon may occur in regard to the falling characteristic of the electric voltage at point ⓒ since the RST signal is at a high level at the same time that the voltage of point ⓒ is still at a level as a result of the delay due to the RC time constant of the word line and the response of inverters 18 and 20 so that the current flows from inverter 20 to RST transistor 16. In the circuit shown in Fig. 8B, as in the case of Fig. 7A, the rising characteristic of the electric voltage on thd word line can be improved. However, an abnormal phenomenon may occur in regard to the falling characteristic of the electric voltage at point ⓒ, for the same reason as in the case of Fig. 7A.

Such a drawback can be eliminated by the embodiment of the invention shown in Fig. 9A. In Fig. 9A, as will be obvious when Fig. 9A is compared with Fig. 7A, Fig. 8A, and Fig. 8B, transistor 16 for discharging word line 12 is connected to the input side of relay buffers 18 and 20, and reset signal RST is supplied to the gate of transistor 16 via transistor 22, which is turned on or off by the potential on the output side of the relay buffers. Further, the gate of transistor 16 is connected to a low-potential point (ground) via transistor 24, which is turned on or off by inverted signal $\overline{RST}$ of reset signal RST. Figure 9B illustrates a circuit of a relay buffer portion of Fig. 9A. Inverters 18 and 20 consist, for example, of a depletion-type load MOS transistor, of which the gate and source are short-circuited, and an enhancement-type driver transistor, the transistors being connected in series. Relay buffers which consume less electric power can be obtained if inverters 18 and 20 consist of complementary MOS circuits. Transistors 16, 22, and 24 operate in the same manner as those of Fig. 9A.

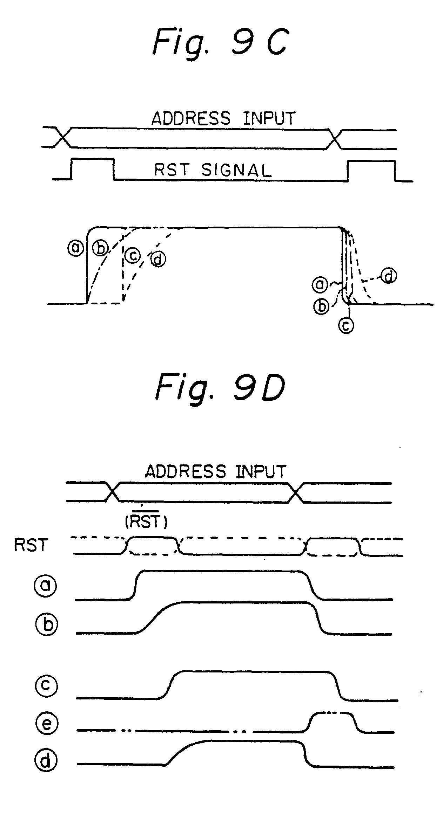

Therefore, the potential at each of the portions of the word line is as denoted in Fig. 9C. That is, at the moment when the potential at point ⓑ begins to rise in accordance with the word line being selected, the potential at point ⓒ may not yet have been begun to rise. Therefore, transistor 16 is not rendered conductive and does not affect the rise in potential at point ⓑ, i.e., the discharge current is not allowed to flow and the waveform is not distorted. When the potential rises at point ⓒ, reset signal RST falls and inverted signal $\overline{RST}$ rises. Accordingly, the gate of transistor 16 is connected to the ground. Namely, transistor 16 is not rendered conductive. When the word line is switched from the nonselected state to the selected state, therefore, the device operates in the same manner as when there is no discharging transistor.

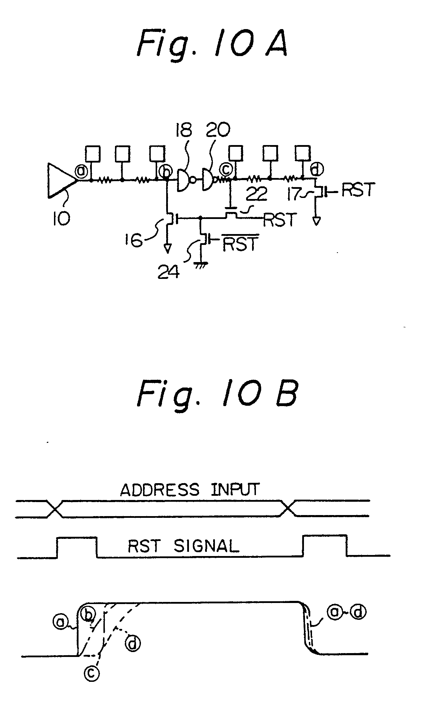

When the word line is switched from the selected state to the nonselected state, the potential at point ⓒ still remains at a high level even after reset signal RST has risen. Transistor 22, therefore, is rendered conductive, and reset signal RST is supplied to the gate of transistor 16 to render it conductive. Consequently, the potential at point ⓑ falls quickly, as shown in Fig. 9C. The potential at points ⓒ and ⓓ also falls quickly. However, the potential at point ⓒ falls after being delayed for the time required for inverters 18 and 20 to invert, and the potential at point ⓓ falls after being further delayed by the time constant established between point ⓒ and point ⓓ. Delay of the falling time at point ⓓ due to the time constant between points ⓒ and ⓓ can be improved by adding RST transistor 17 (Fig. 10A) at point ⓓ to the embodiment shown in Fig. 9A. This embodiment is shown in Fig. 10A, and the waveforms of the embodiment in Fig. 10A are shown in Fig. 10B. In the embodiments shown in Figs. 10A and 10B, the falling characteristic of the voltage at points ⓐ, ⓑ, ⓒ, and ⓓ is not affected by the delay due to time constant RC at each point, and a rapid falling characteristic can be obtained as shown in Fig. 10B.

Figure 9D illustrates a timing chart which shows the relative relationship among reset signal RST, reversed reset signal $\overline{RST}$, and the electric potentials at the points ⓐ, ⓑ, ⓒ, and ⓓ and at the gate of transistor 16.

Reset signal RST is generated when the row address signal is switched. With regard to one word line, therefore, reset signal RST is generated when the word line is switched from the selected state to the nonselected state and when the word line is switched from the nonselected state to the selected state. Further, the reset signal must have a predetermined width so that the word line can be sufficiently discharged. In addition, in the above-mentioned embodiment, one or two transistors for discharging the word line are used; however, it should be understood that more than two transistors may be connected when the word line is longer.

Furthermore, the invention exhibits effects when adapted to large-capacity memories. In addition to MOS static memories, the invention can be suitably adapted to bipolar ($I^2L$) integrated injection logic memories in which the word lines have a high resistance.

## Claims

1. A semiconductor memory device comprising a plurality of memory cells (14) arranged in a row; a word line (12) operatively connected to the plurality of memory cells (14) for selecting the memory cells; drive means (10) connected to the word line (12) for switching the word line (12) from a selected state to a non-selected state and from the non-selected state to the selected state; at least one transistor (16) connected to the word line (12) at a position spaced from the drive means (10) for discharging the word line and a means for turning on the at least one transistor (16), the means for turning on the at least one transistor (16) being adapted to apply a pulse (RST) to the at least one transistor when the associated word line is switched from the selected state to the non-selected state to turn on the at least one transistor for at most a predetermined period of time and including a pulse generating means for generating the pulse characterised in that the means for turning on the at least one transistor (16) further includes a gate means (22) connected between the pulse generating means and the at least one transistor (16), the gate means (22) being responsive to the selected state or non-selected state of the associated word line so as to inhibit passage of the pulse therethrough when the associated word line is in a non-selected state and to allow the pulse to pass therethrough to the at least one transistor (16) when the associated word lines is in the selected state, thereby accelerating the discharge of the word line from the selected state to the non-selected state without affecting the change from the non-selected state to the selected state.

2. A semiconductor memory device according to claim 1, characterised in that the at least one transistor (16) is connected to a substantially middle point of the word line (12).

3. A semiconductor memory device according to claim 1 or claim 2, characterised in that at least one relay buffer (18, 20) is inserted into the word line (12), the relay buffer (18, 20) having an input terminal and an output terminal each connected to the word line (12).

4. A semiconductor memory device according to claim 3, characterised in that the or each relay buffer (18, 20) comprises an amplifier whereby when the word line (12) changes from the selected state to the non-selected state, the amplifier causes a rapid potential change at the position in the word line where the amplifier is connected, and the transistor (16) causes a rapid potential change at the position in the word line where the at least one transistor (16) is connected.

5. A semiconductor memory device according to claim 3 or claim 4, when dependent upon claim 2, characterised in that the relay buffer (18, 20) is inserted at a substantially middle point of the word line (12), and the transistor (16) is connected to the input terminal of the relay buffer (18, 20).

6. A semiconductor memory device according to any of the preceding claims, characterised in that the gate means comprises a first control transistor (22) having a gate connected to the word line; and a second control transistor (24) connected between a gate of the transistor (16) and a ground potential point, wherein the pulse generating means generates a reset signal (RST) and a logical complement of the reset signal (RST), the reset signal being generated for a predetermined period when the word line (12) is switched from the selected state to the non-selected state, the reset signal being applied to the gate of the at least one transistor (16) via the first control transistor (22) and the logical complement of the reset signal being applied to a gate of the second control transistor (24), and the first control transistor (22) being operable to inhibit the application of the reset signal to the at least one transistor (16) when the word line (12) is switched from the non-selected state to the selected state.

7. A semiconductor memory device according to claim 6, characterised in that another transistor (17) is connected to an end of the word line (12) for discharging the word line, the other transistor (17) also being controlled by the reset signal (RST).

8. A semiconductor memory according to claim 6 or claim 7, wherein the gate of the first control transistor (22) is connected to the output terminal of the relay buffer (18, 20).

9. A semiconductor memory according to any of the preceding claims operatively connected to receive address input signals, wherein the means for turning on the at least one transistor (16) generates the pulse by detecting a transition in the address input signals.

## Patentansprüche

1. Halbleiterspeichervorrichtung mit einer Vielzahl von Speicherzellen (14), die in einer Reihe angeordnet sind; einer Wortleitung (12), die wirkungsmäßig mit der Vielzahl von Speicherzellen (14) verbunden ist, um die Speicherzellen auszuwählen; Treibereinrichtungen (10), die mit der Wortleitung (12) verbunden sind, um die Wortleitung (12) von einem ausgewählten Zustand in einem nicht-ausgewählten Zustand und von einem nicht-ausgewählten Zustand in den ausgewählten Zustand zu schalten; wenigstens einem Transitor (16) der mit der Wortleitung (12) an einer Position verbunden ist, die mit Abstand von der Treibereinrichtung (10) angeordnet ist, um die Wortleitung zu entladen; und einer Einrichtung zum Einschalten des wenigstens einen Transistors (16), die angepaßt ist, um einen Impuls (RST) zu dem wenigstens einen Transistor zu übertragen, wenn die zugeordnete Wortleitung von dem ausgewählten Zustand in den nicht-ausgewählten Zustand geschaltet wird, um den wenigstens einen Transistor für höchstens eine vorbestimmte Zeitperiode einzuschalten, und die eine Pulsgeneratoreinrichtung zur Erzeugung des Impulses enthält, dadurch gekennzeichnet, daß die Einrichtung zum Einschalten des wenigstens einen Transistors (16) ferner eine Torschaltungseinrichtung (22) umfaßt, die mit der Pulsgeneratoreinrichtung und dem wenigstens einen Transistor (16) verbunden ist, die Torschaltungseinrichtung (22) auf den ausgewählten Zustand oder nicht-ausgewählten Zustand der zugeordneten Wortleitung anspricht, um so den Durchgang des Impulses zu sperren, wenn die zugeordneteWortleitung in einem nicht-ausgewählten Zustand ist, und um den Impuls zu dem wenigstens einen Transistor (16) hindurchzulassen, wenn die zugeordnete Wortleitung in dem ausgewählten Zustand ist, wodurch die Entladung der Wortleitung von dem ausgewählten Zustand in den nicht-ausgewählten Zustand beschleunigt wird, ohne die Änderung von dem nicht-ausgewählten Zustand in den ausgewählten Zustand zu beeinflussen.

2. Halbleiterspeichervorrichtung nach Anspruch 1, dadurch gekennzeichnet, daß der wenigstens eine Transistor (16) mit einem im wesentlichen mittleren Punkt der Wortleitung (12) verbunden ist.

3. Halbleiterspeichervorrichtung nach Anspruch 1 oder 2, dadurch gekennzeichnet, daß wenigstens ein Relaispuffer (18, 20) in die Wortleitung (12) eingefügt ist, der Relaispuffer (18, 20) einen Eingangsanschluß und einen Ausgangsanschluß hat, von denen jeder mit der Wortleitung (12) verbunden ist.

4. Halbleiterspeichervorrichtung nach Anspruch 3, dadurch gekennzeichnet, daß der oder jeder Relaispuffer (18, 20) einen Verstärker umfaßt, wodurch dann, wenn die Wortleitung (12) von dem ausgewählten Zustand in den nicht-ausgewählten Zustand übergeht, der Verstärker eine schnelle Potentialänderung an der Position in der Wortleitung, wo der Verstärker angeschlossen ist, bewirkt, und der Transistor (16) eine schnelle Potentialänderung an der Position in der Wortleitung, wo der wenigstens eine Transistor (16) verbunden ist, bewirkt.

5. Halbleiterspeichervorrichtung nach Anspruch 3 oder 4, in Verbindung mit Anspruch 2, dadurch gekennzeichnet, daß der Relaispuffer (18, 20) an einem im wesentlichen mittleren Punkt der Wortleitung (12) eingefügt ist und der Transistor (16) mit dem Eingangsanschluß des Relaispuffers (18, 20) verbunden ist.

6. Halbleiterspeichervorrichtung nach einem der vorhergehenden Ansprüche, dadurch gekennzeichnet, daß die Torschaltungseinrichtung einen ersten Steuertransistor (22) umfaßt, der ein Gate hat, das mit der Wortleitung verbunden ist; und ein zweiter Steuertransistor (24) zwischen einem Gate des Transistors (16) und Erdpotential verbunden ist, wobei die Pulsgeneratoreinrichtung ein Rückstellsignal (RST) und ein logisches Komplement des Rückstellsignals (RST) umfaßt, wobei das Rückstellsignal für ein vorbestimmte Periode erzeugt wird, wenn die Wortleitung (12) von dem ausgewählten Zustand in den nicht-ausgewählten Zustand geschaltet wird, und das Rückstellsignal dem Gate des wenigstens eines Transistors (16) über den ersten Steuertransistor (22) zugeführt wird und das logische Komplement des Rückstellsignals dem Gate des zweiten Steuertransistors (24) zugeführt wird, und der erste Steuertransistor (22) betreibbar ist, um die Zuführung des Rückstellsignals zu dem wenigstens einen Transistor (16) zu sperren, wenn die Wortleitung (12) von dem nicht-ausgewählten Zustand in den ausgewählten Zustand geschaltet wird.

7. Halbleiterspeichervorrichtung nach Anspruch 6, dadurch gekennzeichnet, daß ein weiterer Transistor (17) mit dem einen Ende der Wortleitung (12) zum Entladen der Wortleitung verbunden ist, und der andere Transistor (17) auch durch das Rückstellsignal (RST) gesteuert wird.

8. Halbleiterspeichervorrichtung nach Anspruch 6 oder 7, bei dem das Gate des ersten Steuertransistors (22) mit dem Ausgangsanschluß des Relaispuffers (18, 20) verbunden ist.

9. Halbleiterspeichervorrichtung nach einem der vorhergehenden Ansprüche, wirkungsmäßig angeschlossen, um Adresseneingangssignale zu empfangen, wobei die Einrichtung zum Einschalten des wenigstens einen Transistors (16) den Impuls durch Detektieren eines Übergangs in dem Adresseneingangssignal erzeugt.

**Revendications**

1. Dispositif semiconducteur à mémoire comprenant une pluralité de cellules mémoir (14) disposées selon une rangée; une ligne de mots (12) connectée opérativement à la pluralité de cellules mémoire (14) pour sélectionner les cellules mémoires; des moyens de commande (10) connectés à la ligne de mots (12) pour commuter la ligne de mots (12) d'un état sélectionné à un état non sélectionné et, de l'état non sélectionné à l'état sélectionné; au moins un transistor (16) connecté à la ligne de mots (12) à une position espacée des moyens de commande (10) pour décharger la ligne de mots; et un moyen pour rendre passant ledit au moins un transistor (16), le moyen pour rendre passant ledit au moins un transistor (16) étant adapté à appliquer une impulsion (RST) audit au moins un transistor quand la ligne de mots associée est commutée de l'état sélectionné à l'état non sélectionné pour rendre passant ledit au moins un transistor pendant au moins une durée prédéterminée, et comprenant un moyen de génération d'impulsion pour produire l'impulsion, caractérisé en ce que le moyen pour rendre passant ledit au moins un transistor (16) comprend en outre un moyen de porte (22) connecté entre le moyen de génération d'impulsion et ledit au moins un transistor (16), le moyen de porte (22) agissant en réponse à l'état sélectionné ou à l'état non sélectionné de la ligne de mots associée de façon à inhiber le passage de l'impulsion au travers quand la ligne de mots associée est dans un état non sélectionné et à autoriser le passage de l'impulsion au travers vers ledit au moins un transistor (16) quand la ligne de mots associée est dans l'état sélectionné, accélérant ainsi la décharge de la ligne de mots de l'état sélectionné à l'état non sélectionné sans affecter le changement de l'état non sélectionné à l'état sélectionné.

2. Dispositif semiconducteur à mémoire selon la revendication 1, caractérisé en ce que ledit au moins un transistor (16) est connecté à un point sensiblement médian de la ligne de mots (12).

3. Dispositif semiconducteur à mémoire selon la revendication 1 ou la revendication 2, caractérisé en ce qu'au moins un tampon relais (18, 20) est inséré dans la ligne de mots (12), le tampon relais (18, 20) ayant une borne d'entrée et une borne de sortie dont chacune est connectée à la ligne de mots (12).

4. Dispositif semiconducteur à mémoire selon la revendication 3, caractérisé en ce que le ou chaque tampon relais (18, 20) comprend un amplificateur, d'où il résulte que, quand la ligne de mots (12) passe de l'état sélectionné à l'état non sélectionné, l'amplificateur provoque un changement de potentiel rapide à l'emplacement de la ligne de mots où l'amplificateur est connecté, et que le transistor (16) provoque un changement de potentiel rapide à la position de la ligne de mots où ledit au moins un transistor (16) est connecté.

5. Dispositif semiconducteur à mémoire selon la revendication 3 ou la revendication 4, prise dans sa dépendance avec le revendication 2, caractérisé en ce que le tampon relais (18, 20) est inséré à un point sensiblement médian de la ligne de mots (12), et le transistor (16) est connecté à la borne d'entrée du tampon relais (18, 20).

6. Dispositif semiconducteur à mémoire selon l'une quelconque des revendications précédentes, caractérisé en ce que le moyen de porte comprend un premier transistor de commande (22) ayant une grille connectée à la ligne de mots; et un second transistor de commande (24) connecté entre la grille du transistor (16) et un point au potentiel de la masse, dans lequel le moyen de génération d'impulsion produit un signal de remise à zéro (RST) et un complément logique du signal de remise à zéro (RST) le signal de remise à zéro étant produit pendant une durée prédéterminée quand la ligne de mots (12) est commutée de l'état sélectionné à l'état non sélectionné, le signal de remise à zéro étant appliquè à la grille dudit au moins un transistor (16) par l'intermédiaire du premier transistor de commande (22), et le complément logique du signal de remise à zéro étant appliqué à la grille du second transistor de commande (24), et le premier transistor de commande (22) étant actionnable pour inhiber l'application du signal de remise à zéro audit au moins un transistor (16) quand la ligne de mots (12) est commutée de l'état non sélectionné à l'état sélectionné.

7. Dispositif semiconducteur à mémoire selon la revendication 6, caractérisé en ce qu'un autre transistor (17) est connecté à une borne de la ligne de mots (12) pour décharger la ligne de mots, l'autre transistor (17) étant également commandé par le signal de remise à zéro (RST).

8. Mémoire à semiconducteur selon la revendication 6 ou la revendication 7, dans laquelle la grille du premier transistor de commande (22) est connectée à la borne de sortie du tampon relais (18, 20).

9. Mémoire à semiconducteur selon l'une quelconque des revendications précédentes connectée opérativement pour recevoir des signaux d'entrée d'adresse, dans laquelle les moyens pour rendre passant ledit au moins un transistor (16) produisent l'impulsion en détectant une transition dans les signaux d'entrée d'adresse.

## Fig. IA

BL₁   MC   $\overline{BL}_1$

10a

@ WL₁

a

10b

WL₂

Ta   Tb

Ta   Tb

## Fig. IB

@      ⌐SELECTED ⌐NON-SELECTED

@'     ⌐NON-SELECTED ⌐SELECTED

Fig. 2A

Fig. 2B

ADDRESS INPUT

RST SIGNAL

Fig. 3A

Fig. 3B

ADDRESS INPUT

RST SIGNAL

Fig. 4B

ADDRESS INPUT

RST SIGNAL

Fig.5B

Fig. 4A

Fig. 5A

Fig. 6 A

Fig. 6 B

ADDRESS INPUT

RST SIGNAL

Fig. 7A

Fig. 7B

ADDRESS INPUT

RST SIGNAL

0 071 470

## Fig. 8 A

## Fig. 8 B

## Fig. 9 A

## Fig. 9 B

## Fig. 9 C

ADDRESS INPUT

RST SIGNAL

ⓐ ⓑ ⓒ ⓓ

ⓐ ⓑ ⓒ ⓓ

## Fig. 9 D

ADDRESS INPUT

($\overline{RST}$)

RST

ⓐ

ⓑ

ⓒ

ⓔ

ⓓ

6

# Fig. 10 A

18  20

# Fig. 10 B

ADDRESS INPUT

RST SIGNAL